(19) Europäisches Patentamt European Patent Office Office européen des brevets

(11) **EP 2 940 863 B1**

(12) **FASCICULE DE BREVET EUROPEEN**

(45) Date de publication et mention
de la délivrance du brevet:
**31.07.2019 Bulletin 2019/31**

(51) Int Cl.:
***H03G 7/00*** *(2006.01)*

(21) Numéro de dépôt: **15164018.2**

(22) Date de dépôt: **17.04.2015**

(54) **METHODE DE COMPRESSION ET COMPRESSEUR DE DYNAMIQUE AUDIO**

KOMPRESSIONSMETHODE UND DYNAMIKKOMPRESSOR FÜR AUDIO

COMPRESSION METHOD AND DYNAMIC AUDIO COMPRESSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **02.05.2014 FR 1454022**

(43) Date de publication de la demande:
**04.11.2015 Bulletin 2015/45**

(73) Titulaire: **Hurtado-Huyssen, Antoine-Victor
75008 Paris (FR)**

(72) Inventeur: **Hurtado-Huyssen, Antoine-Victor
75008 Paris (FR)**

(74) Mandataire: **Demulsant, Xavier
Dejade & Biset
35, rue de Châteaudun
75009 Paris (FR)**

(56) Documents cités:
**EP-A1- 2 149 985      US-A1- 2011 268 301**

- **ROBINSON C E ET AL: "Y2-1. THE
INTELLIGIBILITY OF SPEECH PROCESSED BY
DELAYED LONG-TIME-AVERAGED
COMPRESSION AMPLIFICATION", THE
JOURNAL OF THE ACOUSTICAL SOCIETY OF
AMERICA, AMERICAN INSTITUTE OF PHYSICS
FOR THE ACOUSTICAL SOCIETY OF AMERICA,
NEW YORK, NY, US, vol. 54, no. 1, 1 janvier 1978
(1978-01-01), page 314, XP000872220, ISSN:
0001-4966, DOI: 10.1121/1.1978243**

## Description

La présente invention se rapporte généralement aux méthodes et systèmes de traitement d'un signal audio, et particulièrement aux méthodes et systèmes de compression de la dynamique audio d'un signal audio.

La compression de la dynamique d'un signal audio, communément connue sous l'acronyme DRC pour « Dynamic Range Compression », désigne la compression de l'étendue ou la plage, ou encore l'écart (mesurée en décibels) entre l'amplitude la plus forte et l'amplitude la plus faible d'un programme audio.

En effet, un compresseur audio est configuré pour réduire la dynamique, ou autrement dit la plage d'intensité sonore, d'un signal audio lors de son évolution temporelle. Pour cela, le compresseur audio atténue les sons forts (pics ou crêtes du signal), ou alternativement rehausse les sons faibles du signal audio. Il s'ensuit que la différence entre les forts niveaux sonores et les faibles niveaux sonores du signal audio se voit réduite.

La compression de la dynamique audio peut avoir pour effet de

- protéger l'émetteur et/ou l'auditeur d'intensités sonores trop importantes, généralement désagréables voire destructrices, en atténuant ces dernières ;
- lisser les irrégularités d'un son afin de le rendre plus homogène en volume ;
- transformer un signal sonore (mixage, « mastering » musical ou cinématographique) pour être écouté en condition particulières : maison, voiture, avion.

Dans la pratique, la compression de la dynamique d'un signal audio consiste, généralement, à lui appliquer une courbe de gain (ou de correction). Ceci fait d'un compresseur audio un amplificateur à gain variable dont le gain est ajusté dynamiquement en fonction du niveau de puissance instantanée du signal d'entrée autour d'un certain niveau nominal.

En particulier, cette courbe de gain, dont la méthode de calcul caractérise le compresseur audio, joue un rôle déterminant dans la qualité du signal audio dont la dynamique est compressée.

En effet, appliquer un gain inapproprié (notamment, avec un taux de compression trop important) peut dénaturer le son du signal audio, voire le saturer. En outre, des variations brusques dans la courbe de gain peuvent produire des compressions brutales désagréables.

Le document (ROBINSON C. E. et al., "The Intelligibility of Speech Processed by Delayed Long-Time-Averaged Compression Amplification.", J. Acoust. Soc. Am.vol.54, no.1, 1978-01-01) divulgue une méthode de traitement d'un signal compressé.

Le document EP2149985 décrit une méthode de normalisation adaptative d'un signal audio.

Un objet de la présente invention est de proposer une courbe de gain permettant de lisser au mieux possible les variations du volume sonore occasionnées par la compression.

Un autre objet de la présente invention est de limiter les effets de pompage occasionnés par les méthodes existantes de compression.

Un autre objet de la présente est de proposer un compresseur audio et une méthode de compression d'un signal audio qui permettent une meilleure conservation de la sensation de dynamique.

A ces fins, l'invention se rapporte, selon un premier aspect, à une méthode de compression de la dynamique audio d'un signal audio, cette méthode comprenant,

- une étape d'acquisition d'un signal audio ;
- une étape de sélection d'un premier instant du signal audio ;
- une étape de calcul d'une pluralité de gains partiels correspondants, respectivement, à une pluralité de fenêtre d'observation du signal audio centrées sur ledit premier instant, la largeur de ces fenêtres d'observations suivant une progression géométrique de raison et de premier terme prédéfinis ;
- une étape de sommation des gains partiels calculés en un premier terme correctif ;
- une étape d'application du premier terme correctif au signal audio audit premier instant.

La méthode comprend en outre, selon diverses réalisations, les étapes suivantes, le cas échéant combinées :

- une étape de sélection d'un deuxième instant du signal audio, la durée entre le premier instant et le deuxième instant étant sensiblement égale au temps d'intégration de l'oreille humaine ;
- une étape de calcul d'une pluralité de gains partiels correspondants, respectivement, à une pluralité de fenêtre d'observation du signal audio centrées sur ledit deuxième instant, la largeur de ces fenêtres d'observations suivant ladite progression géométrique ;
- une étape de sommation des gains partiels calculés en un deuxième terme correctif ;
- une étape d'application du deuxième terme correctif au signal audio audit deuxième instant ;
- une étape de calcul d'un gain variable allant linéairement dudit premier terme correctif audit deuxième terme correctif ;
- une étape d'application dudit gain variable au signal audio sur la durée entre ledit premier instant et ledit deuxième instant.

Dans cette méthode, le gain partiel est calculé comme suit :

$$G_{i,n} = \left(L_0 - L_{i,n}\right)\frac{R_n - 1}{R_n}$$

où

- $G_{i,n}$ est le gain partiel à un instant $t_i$ et à une fenêtre d'observation d'ordre $n$ de ladite progression géométrique, $t_i$ étant ledit premier ou ledit deuxième instant ;
- $L_{i,n}$ est le niveau en décibels de la moyenne énergétique du signal audio sur ladite fenêtre d'observation ;
- $L_0$ est le niveau nominal en décibels du signal audio; et
- $R_n$ est un taux de compression prédéfini à appliquer sur la fenêtre d'observation d'ordre n.

La fenêtre d'observation est définie par la fenêtre temporelle $[t_{i-2n-1}, t_{i+2n-1}[$ centrée sur l'instant $t_i$, $t_i$ étant le premier instant ou le deuxième instant, de sorte que la raison et le premier terme de ladite progression géométrique sont, respectivement, égaux à deux et à la durée entre ledit premier instant et ledit deuxième instant.

L'invention se rapporte, selon un deuxième aspect, à un compresseur audio pour compresser la dynamique audio d'un signal audio, ce compresseur audio comprenant

- des moyens pour acquérir un signal audio ;
- des moyens configurés pour sélectionner un premier instant du signal audio ;
- des moyens pour calculer une pluralité de gains partiels correspondants, respectivement, à une pluralité de fenêtre d'observation du signal audio centrées sur ledit premier instant, la largeur de ces fenêtres d'observations suivant une progression géométrique de raison et de premier terme prédéfinis ;
- des moyens pour sommer les gains partiels calculés en un premier terme correctif ;
- des moyens pour appliquer le premier terme correctif au signal audio audit premier instant.

Le système ci-dessus comprend, en outre, selon diverses réalisations, les moyens suivants, le cas échéant en combinaison :

- des moyens pour sélectionner un deuxième instant du signal audio, la durée entre le premier instant et le deuxième instant étant sensiblement égale au temps d'intégration de l'oreille humaine ;
- des moyens pour calculer une pluralité de gains partiels correspondants, respectivement, à une pluralité de fenêtre d'observation du signal audio centrées sur ledit deuxième instant, la largeur de ces fenêtres d'observations suivant ladite progression géométrique ;
- des moyens pour sommer les gains partiels calculés en un deuxième terme correctif ;
- des moyens pour appliquer le deuxième terme correctif au signal audio audit deuxième instant ;
- des moyens de calcul d'un gain variable allant linéairement dudit premier terme correctif audit deuxième terme correctif ;
- des moyens pour appliquer ledit gain variable au signal audio sur la durée entre ledit premier instant et ledit deuxième instant.

L'invention se rapporte, selon un troisième aspect, à un produit programme d'ordinateur implémenté sur un support mémoire, susceptible d'être mis en oeuvre au sein d'une unité de traitement informatique et comprenant des instructions pour la mise en oeuvre de la méthode résumée ci-dessus.

D'autres objets et avantages de l'invention apparaîtront à la lumière de la description de modes de réalisation, faite ci-après en référence aux dessins annexés dans lesquels :

- la figure 1 illustre un signal audio découpé en trames régulières;
- la figure 2 illustre des fenêtres d'observations du signal audio ;
- la figure 3 illustre une méthode de calcul de la courbe de gain d'un compresseur audio ;
- la figure 4 illustre un compresseur audio.

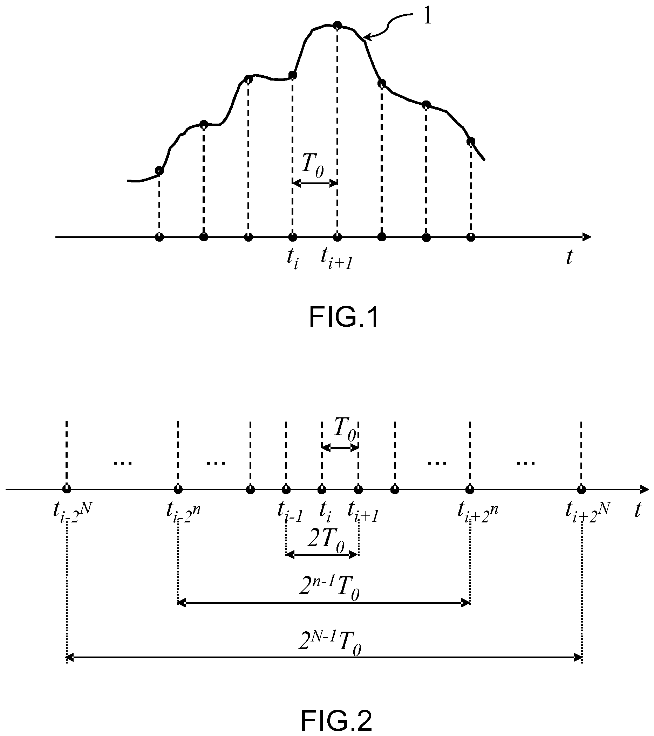

Sur la figure 1 est affiché un signal audio 1 découpé en trames de durée constante $T_0$ (c.à.d. en parcelles ou tranches temporelles régulières de durée $T_0$).

Ces trames sont indexées par les instants $t_i = i.T_0$. Une trame du signal audio **1** correspond au segment allant de l'instant $t_i$ à l'instant $t_{i+1}$.

De préférence, la durée $T_0$ d'une trame temporelle du signal audio 1 est de l'ordre du temps d'intégration de l'oreille humaine (de 10 à 100 millisecondes). Dans un mode de réalisation, $T_0$ est de l'ordre de dizaines de millisecondes telle que 5 ms, 10 ms, 20 ms ou 30 ms.

En se référent à la figure 2, on associe, à chaque instant $t_i$, un terme correctif $S_i$ défini comme suit :

$$S_i = \sum_{n=1}^{N} G_{i,n}$$

où

- $G_{i,n}$ est un gain partiel correspondant à une fenêtre d'observation d'ordre n autour de l'instant $t_i$.
- $N$ est un entier naturel prédéfini.

En d'autres termes, le terme correctif $S_i$ est obtenu par la somme d'une série de gains partiels $G_{i,n}$ correspondants à différentes fenêtres d'observation centrées sur l'instant $t_i$ et de largeur différent.

Une fenêtre d'observation d'ordre n autour de l'instant $t_i$ est définie par la fenêtre temporelle $[t_{i-2n-1}, t_{i+2n-1}[$ (voir figure 2). Sur cette fenêtre temporelle, le gain partiel $G_{i,n}$ d'ordre $n$ autour de l'instant $t_i$ est défini par l'équation suivante :

$$G_{i,n} = (L_0 - L_{i,n}) \frac{R_n - 1}{R_n}$$

Où

- $L_{i,n}$ est le niveau en décibels de la moyenne énergétique du signal audio **1** sur la fenêtre temporelle considérée $[t_{i-2n-1}, t_{i+2n-1}[$ ;
- $L_0$ est le niveau nominal en décibels du signal audio **1**; et
- $R_n$ est un taux de compression prédéfini à appliquer sur la fenêtre d'observation d'ordre $n$.

Il s'ensuit que, pour une fenêtre temporelle $[t_{i-2n-1}, t_{i+2n-1}[$ donnée, le gain partiel $G_{i,n}$ est fonction de l'écart mesuré entre la moyenne énergétique $L_{i,n}$ du signal sur la largeur de cette fenêtre et le niveau nominal $L_0$ du signal audio.

Par ailleurs, il est à noter que la largeur des fenêtres d'observation $(2T_0,...,2^{n-1}T_0,...,2^{N-1}T_0)$ (voir figure 2) suit une progression géométrique jusqu'à un ordre $N$. La valeur de N est choisie de sorte à mieux conserver la sensation de la dynamique du signal audio. Dans un mode de réalisation, $N$ est égal à 10.

Avantageusement, l'utilisation de fenêtres d'observation dont la largeur varie selon une progression géométrique permet de limiter les effets de pompage et de variation brutale de la compression.

Ainsi, les gains partiels $G_{i,n}$ correspondants aux $N$ fenêtres d'observation dont la largeur suit une progression géométrique de raison deux et de premier terme $T_0$ sont sommés pour obtenir le terme correctif $S_i$ associé à l' instant $t_i$ du signal audio **1**.

Vu que le calcul des termes correctifs $S_i$ utilise des fenêtres d'observation centrées sur l'instant $t_i$, et donc nécessite des segments du signal audio antérieurs et postérieurs à l'instant $t_i$, il est supposé qu' au début du signal audio ($t_i = 0$), ainsi qu'à sa fin, ses segments audio sont égaux au niveau nominal $L_0$.

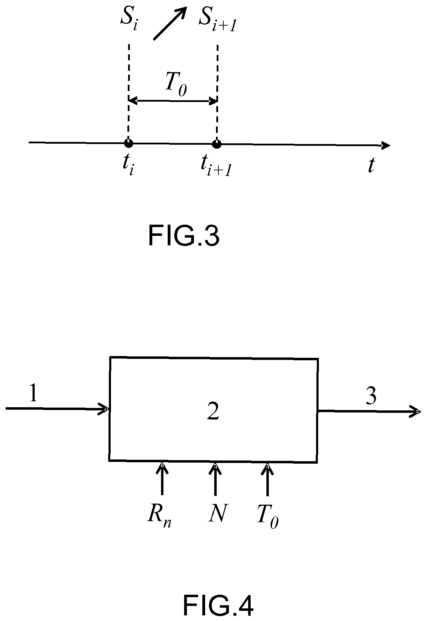

Un gain variable allant linéairement (voir figure 3) du terme correctif $S_i$ (correspondant à l'instant $t_i$) au terme correctif $S_{i+1}$ (correspondant à l'instant $t_{i+1}$) est appliqué au signal audio 1 sur la fenêtre temporelle $[t_i, t_{i+1}[$. Il en résulte que, entre les instants $t_i$ et $t_{i+1}$, le segment élémentaire du signal audio 1 reçoit un gain allant de façon linéaire du terme correctif ponctuel $S_i$ (correspondant à l'instant $t_i$) au terme correctif $S_{i+1}$ (correspondant à l'instant $t_{i+1}$).

Autrement dit, la courbe de gain en décibels à appliquer au signal audio sur la fenêtre $[t_i, t_{i+1}[$ est de la forme suivante :

$$S(t) = \frac{S_{i+1} - S_i}{T_0} t + \frac{t_{i+1}S_i - t_i S_{i+1}}{T_0}$$

Ainsi, le calcul des termes correctifs $S_i$ aux différents instants $t_i$ permet d'obtenir la courbe de gain à appliquer au signal audio d'entrée. La courbe de correction résultante est linéaire par morceaux, autrement dit change de linéarité (ou de pente) aux instants $t_i$.

Afin de réduire les écarts de niveaux sonores au sein du signal audio **1** autour d'un niveau nominal $L_0$, cette courbe de gain est appliquée au signal audio d'entrée. L'amplitude du signal audio à un instant $t$ donné est multipliée par la valeur du terme correctif $S(t)$ à cet instant de la courbe de gain.

Le compresseur audio agit, ainsi, dans le temps $t$ sur le signal audio d'entrée de façon variable suivant le niveau sonore du signal à chaque instant et le terme correctif de la courbe de gain à cet instant. Pour des niveaux sonores proches du niveau nominal, la valeur en sortie reste quasi-inchangée (pente de la courbe de gain proche de 1). A défaut, à partir d'un certain niveau sonore, un terme correctif est appliqué (pente de la courbe de gain différente de 1).

En se reportant à la figure 4, le compresseur audio **2** utilise, comme données, un taux de compression $R_n$ donné pour chaque fenêtre d'ordre $n$, la durée $T_0$, et le nombre $N$ de fenêtres d'observations, pour la compression de la dynamique du signal audio **1** en entrée. L'application de la courbe de gain, calculée par le compresseur audio **2**, au signal audio 1 d'entrée donne en sortie un signal audio **3** dont la dynamique est compressée.

Avantageusement, plusieurs plages dynamiques du signal audio peuvent être traitées avec différents taux de compression.

Avantageusement, la méthode de compression de dynamique décrite ci-dessus peut être implémentée sous forme logicielle (en tant que plug-in ou application par exemple) ou hardware dans une console, un rack externe ou une station de travail digitale de traitement sonore.

**Revendications**

1. Méthode de compression de la dynamique audio d'un signal audio (1), cette méthode comprenant,

   - une étape d'acquisition d'un signal audio (1) ;
   - une étape de sélection d'un premier instant ($t_i$) du signal audio (1) ;
   - une étape de calcul d'une pluralité de gains partiels correspondants, respectivement, à une pluralité de fenêtres d'observations du signal audio (1) centrées sur ledit premier instant ($t_i$), la largeur de ces fenêtres d'observations suivant une progression géométrique de raison et de premier terme prédéfinis ;
- une étape de sommation des gains partiels calculés en un premier terme correctif ($S_i$) ;
- une étape d'application du premier terme correctif ($S_i$) au signal audio (1) audit premier instant ($t_i$).

2. Méthode selon la revendication précédente, comprenant, en outre,

- une étape de sélection d'un deuxième instant ($t_{i+1}$) du signal audio (1), la durée ($T_0$) entre le premier instant ($t_i$) et le deuxième instant ($t_{i+1}$) étant sensiblement égale au temps d'intégration de l'oreille humaine ;
- une étape de calcul d'une pluralité de gains partiels correspondants, respectivement, à une pluralité de fenêtres d'observations du signal audio (1) centrées sur ledit deuxième instant ($t_{i+1}$), la largeur de ces fenêtres d'observations suivant ladite progression géométrique ;
- une étape de sommation des gains partiels calculés en un deuxième terme correctif ($S_{i+1}$) ;
- une étape d'application du deuxième terme correctif ($S_{i+1}$) au signal audio (1) audit deuxième instant ($t_{i+1}$).

3. Méthode selon la revendication précédente, comprenant, en outre,

- une étape de calcul d'un gain variable allant linéairement dudit premier terme correctif ($S_i$) audit deuxième terme correctif ($S_{i+1}$) ;
- une étape d'application dudit gain variable au signal audio (1) sur la durée ($T_0$) entre ledit premier instant ($t_i$) et ledit deuxième instant ($t_{i+1}$).

4. Méthode selon l'une quelconque des revendications 2 ou 3, dans laquelle le gain partiel est calculé comme suit :

$$G_{i,n} = \left(L_0 - L_{i,n}\right) \frac{R_n - 1}{R_n}$$

où

- $G_{i,n}$ est le gain partiel à un instant $t_i$ et à une fenêtre d'observation d'ordre n de ladite progression géométrique, $t_i$ étant ledit premier ou ledit deuxième instant ;
- $L_{i,n}$ est le niveau en décibels de la moyenne énergétique du signal audio sur ladite fenêtre d'observation ;
- $L_0$ est le niveau nominal en décibels du signal audio; et
- $R_n$ est un taux de compression prédéfini à appliquer sur la fenêtre d'observation d'ordre $n$.

5. Méthode selon l'une quelconque des revendications 2 à 4, dans laquelle la fenêtre d'observation d'ordre n de ladite progression géométrique est définie par la fenêtre temporelle [$t_{i-2n-1}$, $t_{i+2n-1}$[ centrée sur l'instant $t_i$, $t_i$ étant le premier instant ou le deuxième instant, de sorte que la raison et le premier terme de ladite progression géométrique sont, respectivement, égaux à deux et à la durée ($T_0$) entre ledit premier instant et ledit deuxième instant.

6. Méthode selon l'une quelconque des revendications 2 à 5, dans laquelle ladite durée ($T_0$) entre ledit premier instant ($t_i$) et ledit deuxième instant ($t_{i+1}$) est sensiblement égale à 10 millisecondes.

7. Un compresseur audio (2) pour compresser la dynamique audio d'un signal audio (1), ce compresseur audio comprenant

- des moyens pour acquérir un signal audio (1) ;
- des moyens configurés pour sélectionner un premier instant ($t_i$) du signal audio (1) ;
- des moyens pour calculer une pluralité de gains partiels correspondants, respectivement, à une pluralité de fenêtres d'observations du signal audio (1) centrées sur ledit premier instant ($t_i$), la largeur de ces fenêtres d'observations suivant une progression géométrique de raison et de premier terme prédéfinis ;
- des moyens pour sommer les gains partiels calculés en un premier terme correctif ($S_i$) ;
- des moyens pour appliquer le premier terme correctif ($S_i$) au signal audio (1) audit premier instant ($t_i$).

8. Le compresseur audio (2) selon la revendication précédente comprenant, en outre,

- des moyens pour sélectionner un deuxième instant ($t_{i+1}$) du signal audio (1), la durée ($T_0$) entre le premier instant ($t_i$) et le deuxième instant ($t_{i+1}$) étant sensiblement égale au temps d'intégration de l'oreille humaine ;
- des moyens pour calculer une pluralité de gains partiels correspondants, respectivement, à une pluralité de fenêtres d'observations du signal audio centrées sur ledit deuxième instant ($t_{i+1}$), la largeur de ces fenêtres d'observations suivant ladite progression géométrique ;
- des moyens pour sommer les gains partiels calculés en un deuxième terme correctif ;
- des moyens pour appliquer le deuxième terme correctif au signal audio audit deuxième instant.

9. Le compresseur audio (2) selon la revendication précédente comprenant, en outre,

- des moyens de calcul d'un gain variable allant linéairement dudit premier terme correctif audit deuxième terme correctif ;
- des moyens pour appliquer ledit gain variable au signal audio sur la durée entre ledit premier instant et ledit deuxième instant.

10. Produit programme d'ordinateur implémenté sur un support mémoire, susceptible d'être mis en oeuvre au sein d'une unité de traitement informatique et comprenant des instructions pour la mise en oeuvre de la méthode selon l'une des revendications 1 à 6.

**Patentansprüche**

1. Kompressionsverfahren der Audiodynamik eines Audiosignals (1), wobei dieses Verfahren umfasst:

   - einen Erwerbsschritt eines Audiosignals (1);
   - einen Auswahlschritt eines ersten Moments ($t_i$) des Audiosignals (1);
   - einen Berechnungsschritt einer Vielzahl von teilweisen Verstärkungen, die jeweils einer Vielzahl von Beobachtungsfenstern des Audiosignals (1) entsprechen, welche auf dem genannten ersten Moment ($t_i$) zentriert sind, wobei die Breite dieser Beobachtungsfenster eine geometrische Progression des vordefinierten Grundes und der vordefinierten Frist folgt;
   - einen Summierungsschritt der teilweisen Verstärkungen, die in einer ersten korrektiven Frist ($S_i$) berechnet sind;
   - einen Anwendungsschritt der ersten korrektiven Frist ($S_i$) auf das Audiosignal (1) des genannten ersten Moments ($t_i$).

2. Verfahren gemäß dem voranstehenden Anspruch, umfassend darüber hinaus

   - einen Auswahlschritt eines zweiten Moments ($t_{i+1}$) des Audiosignals (1), wobei die Dauer ($T_0$) zwischen dem ersten Moment ($t_i$) und dem zweiten Moment ($t_{i+1}$) deutlich gleich der Integrationszeit des menschlichen Ohrs ist;
   - einen Berechnungsschritt einer Vielzahl von teilweisen Verstärkungen, die jeweils einer Vielzahl von Beobachtungsfenstern des Audiosignals (1) entsprechen, die auf dem genannten zweiten Moment ($t_{i+1}$) zentriert sind, wobei die Breite dieser Beobachtungsfenster der genannten geometrischen Progression folgt;
   - einen Summierungsschritt der teilweisen Verstärkungen, die in einer zweiten korrektiven Frist ($S_{i+1}$) berechnet sind;
   - einen Anwendungsschritt der zweiten korrektiven Frist ($S_{i+1}$) auf das Audiosignal (1) des genannten zweiten Moments ($t_{i+1}$).

3. Verfahren gemäß dem voranstehenden Anspruch, umfassend darüber hinaus

   - einen Berechnungsschritt einer variablen Verstärkung, die linear von der genannten ersten korrektiven Frist ($S_i$) zu der genannten zweiten korrektiven Frist ($S_{i+1}$) reicht;
   - einen Anwendungsschritt der genannten variablen Verstärkung auf das Audiosignal (1) über die Dauer ($T_0$) zwischen dem genannten ersten Moment ($t_i$) und dem genannten zweiten Moment ($t_{i+1}$).

4. Verfahren gemäß irgendeinem der Ansprüche 2 oder 2, bei dem die teilweise Verstärkung wie folgt berechnet ist:

$$G_{i,n} = \left(L_0 - L_{i,n}\right)\frac{R_n - 1}{R_n}$$

wobei

   - $G_{i,n}$ die teilweise Verstärkung in einem Moment $t_i$ und in einem Beobachtungsfenster der Reihenfolge n der genannten geometrischen Progression ist, wobei $t_i$ der genannte erste oder der genannte zweite Moment ist;
   - $L_{i,n}$ das Dezibelniveau des energetischen Durchschnitts des Audiosignals auf dem genannten Beobachtungsfenster ist;
   - $L_0$ das nominale Dezibelniveau des Audiosignals ist; und
   - $R_n$ eine vordefinierte Kompressionsrate ist, die auf das Beobachtungsfenster der Reihenfolge n anzuwenden ist.

5. Verfahren gemäß irgendeinem der Ansprüche 2 bis 4, bei dem das Beobachtungsfenster der Reihenfolge der genannten geometrischen Progression durch das zeitliche Fenster [$t_{i-2^{n-1}}$, $t_{i+2^{n-1}}$] definiert ist, das auf den Moment $t_i$ zentriert ist, wobei $t_i$ derart der erste Moment oder der zweite Moment ist, dass der Grund und die erste Frist der genannten geometrischen Progression jeweils gleich zwei und der Dauer ($T_0$) zwischen dem genannten ersten Moment und dem genannten zweiten Moment sind.

6. Verfahren gemäß irgendeinem der Ansprüche 2 bis 5, bei dem die genannte Dauer ($T_0$) zwischen dem genannten ersten Moment ($t_i$) und dem genannten zweiten Moment ($t_{i+1}$) deutlich gleich 10 Millisekunden beträgt.

7. Audiokompressor (2) zum Komprimieren der Audiodynamik eines Audiosignals (1), wobei dieser Audiokompressor umfasst

- Mittel zum Erwerben eines Audiosignals (1);
- Mittel, die konfiguriert sind, um einen ersten Moment ($t_i$) des Audiosignals (1) auszuwählen;
- Mittel zum Berechnen einer Vielzahl von teilweisen Verstärkungen, die jeweils einer Vielzahl von Beobachtungsfenstern des Audiosignals (1) entsprechen, die auf dem genannten ersten Moment ($t_i$) zentriert sind, wobei die Breite dieser Beobachtungsfenster einer geometrischen Progression des vordefinierten Grundes und der vordefinierten Frist folgt;
- Mittel zum Summieren der teilweisen Verstärkungen, die in einer ersten korrektiven Frist ($S_i$) berechnet sind,
- Mittel zum Anwenden der ersten korrektiven Frist ($S_i$) auf das Audiosignal (1) des ersten Moments ($t_i$).

**8.** Audiokompressor (2) gemäß dem voranstehenden Anspruch, umfassend darüber hinaus

- Mittel zum Auswählen eines zweiten Moments ($t_{i+1}$) des Audiosignals (1), wobei die Dauer ($T_0$) zwischen dem ersten Moment (ti) und dem zweiten Moment ($t_{i+1}$) deutlich gleich der Integrationszeit des menschlichen Ohrs ist;
- Mittel zum Berechnen einer Vielzahl von teilweisen Verstärkungen, die jeweils einer Vielzahl von Beobachtungsfenstern des Audiosignals entsprechen, welche auf dem genannten zweiten Moment ($t_{i+1}$) zentriert sind, wobei die Breite dieser Beobachtungsfenster der genannten geometrischen Progression folgt;
- Mittel zum Summieren der teilweisen Verstärkungen, die in einer zweiten korrektiven Frist berechnet sind;
- Mittel zum Anwenden der zweiten korrektiven Frist auf das Audiosignal des zweiten Moments.

**9.** Audiokompressor (2) gemäß dem voranstehenden Anspruch, umfassend darüber hinaus

- Berechnungsmittel einer variablen Verstärkung, die linear von der genannten ersten korrektiven Frist zu der genannten zweiten korrektiven Frist reicht;
- Mittel zum Anwenden der genannten variablen Verstärkung auf das Audiosignal über die Dauer zwischen dem genannten ersten Moment und dem genannten zweiten Moment.

**10.** Computerprogrammprodukt, das auf einem Speicherträger implementiert ist, der geeignet ist, innerhalb einer Informatik-Verarbeitungseinheit umgesetzt zu sein und umfassend Anweisungen für die Umsetzung des Verfahrens gemäß einem der Ansprüche 1 bis 6.

**Claims**

**1.** An audio dynamic range compression method for an audio signal (1), this method comprising:

- a step of acquiring an audio signal (1);
- a step of selecting a first time instant ($t_i$) of the audio signal (1);
- a step of calculating a plurality of partial gains corresponding, respectively, to a plurality of observation windows of the audio signal (1) which are centred on said first time instant ($t_i$), the width of these observation windows following a geometric progression with predefined common difference and first term;
- a step of summing the partial gains calculated as a first correcting term ($S_i$);
- a step of applying the first correcting term ($S_i$) to the audio signal (1) at said first time instant ($t_i$).

**2.** The method according to the preceding claim, further comprising:

- a step of selecting a second time instant ($t_{i+1}$) of the audio signal (1), the duration ($T_o$) between the first time instant ($t_i$) and the second time instant ($t_{i+1}$) being substantially equal to the integration time of the human ear;
- a step of calculating a plurality of partial gains corresponding, respectively, to a plurality of observation windows of the audio signal (1) which are centred on said second time instant ($t_{i+1}$), the width of these observation windows following said geometric progression;
- a step of summing the partial gains calculated as a second correcting term ($S_{i+1}$);
- a step of applying the second correcting term ($S_{i+1}$) to the audio signal (1) at said second time instant ($t_{i+1}$).

**3.** The method according to the preceding claim, further comprising:

- a step of calculating a variable gain linearly ranging from said first correcting term ($S_i$) to said second correcting term ($S_{i+1}$);
- a step of applying said variable gain to the audio signal (1) over the duration ($T_0$) between said first time instant ($t_i$) and said second time instant ($t_{i+1}$).

**4.** The method according to any of claims 2 and 3, wherein the partial gain is calculated as follows:

$$G_{i,n} = \left( L_0 - L_{i,n} \right) \frac{R_n - 1}{R_n}$$

where

- $G_{i,n}$ is the partial gain at a time instant $t_i$ and at a $n$-order observation window of said geometric progression, $t_i$ being said first or said second time instant;
- $L_{i,n}$ is the level in decibels of the energy mean of the audio signal on said observation window;
- $L_0$ is the nominal level in decibels of the audio signal; and
- $R_n$ is a predefined compression rate to be applied to the n-order observation window.

5. The method according to any of claims 2 to 4, wherein the n-order observation window of said geometric progression is defined by the time window $[t_{i-2n-1}, t_{i+2n-1}[$ centred on the time instant $t_i$, $t_i$ being the first time instant or the second time instant, such that the common difference and the first term of said geometric progression are, respectively, equal to two and to the duration ($T_0$) between said first time instant and said second time instant.

6. The method according to any of claims 2 to 5, wherein said duration ($T_0$) between said first time instant ($t_i$) and said second time instant ($t_{i+1}$) is substantially equal to 10 milliseconds.

7. An audio compressor (2) for the audio dynamic range compression of an audio signal (1), this audio compressor comprising

- means for acquiring an audio signal (1);
- means configured to select a first time instant ($t_i$) of the audio signal (1);
- means for calculating a plurality of partial gains corresponding, respectively, to a plurality of observation windows of the audio signal (1) which are centred on said first time instant ($t_i$), the width of these observation windows following a geometric progression with predefined common difference and first term;
- means for summing the partial gains calculated as a first correcting term ($S_i$);
- means for applying the first correcting term ($S_i$) to the audio signal (1) at said first time instant ($t_i$).

8. The audio compressor (2) according to the preceding claim, further comprising:

- means for selecting a second time instant ($t_{i+1}$) of the audio signal (1), the duration ($T_0$) between the first time instant ($t_i$) and the second time instant ($t_{i+1}$) being substantially equal to the integration time of the human ear;
- means for calculating a plurality of partial gains corresponding, respectively, to a plurality of observation windows of the audio signal which are centred on said second time instant ($t_{i+1}$), the width of these observation windows following said geometric progression;
- means for summing the partial gains calculated as a second correcting term;
- means for applying the second correcting term to the audio signal at said second time instant.

9. The audio compressor (2) according to the preceding claim, further comprising:

- means for calculating a variable gain linearly ranging from said first correcting term to said second correcting term;
- means for applying said variable gain to the audio signal over the duration between said first time instant and said second time instant.

10. A computer program product implemented on a storage medium, likely to be performed within a computer processing unit and comprising instructions for performing the method according to one of claims 1 to 6.

FIG.1

FIG.2

$S_i$ $S_{i+1}$

$T_0$

$t_i$ $t_{i+1}$ $t$

## FIG.3

1 2 3

$R_n$ $N$ $T_0$

## FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2149985 A

**Littérature non-brevet citée dans la description**

- **ROBINSON C. E. et al.** The Intelligibility of Speech Processed by Delayed Long-Time-Averaged Compression Amplification. *J. Acoust. Soc. Am.,* 01 Janvier 1978, vol. 54 (1